# EUROPÄISCHE PATENTSCHRIFT

(11) **EP 0 424 961 B1**
(45) Veröffentlichungstag und Bekanntmachung des Hinweises auf die Patenterteilung: **03.04.1996**
(21) Anmeldenummer: 90120592.2
(22) Anmeldetag: 26.10.1990
(51) Int. Cl.: H05K 13/00

(54) **Bestückungsgerät**
Mounting apparatus
Appareil à planter les composants

(30) Priorität: 27.10.1989 DE 3935930
(43) Veröffentlichungstag der Anmeldung: 02.05.1991
(73) Patentinhaber: Fritsch, Markus, D-92280 Kastl (DE)
(72) Erfinder: Fritsch, Adalbert, (DE)
(74) Vertreter: Schmidt-Evers, Jürgen, Dipl.-Ing.

(56) Entgegenhaltungen:
- EP-A- 0 062 335
- EP-A- 0 118 689
- EP-A- 0 338 454
- US-A- 4 905 370
- SIEMENS COMPONENTS, Heft 6, 24. Jahrgang, November/Dezember 1986, München, DE; DIETER FRIEDRICH, RAINER ROHM: "SMT-die neue Bestückungstechnik für Flachbaugruppen",Seiten 211-221

## Beschreibung

Die Erfindung betrifft ein Bestückungsgerat zum Bestücken von Leiterplatten mit Bauteilen, wie z.B. SMD-Bauteilen, nach dem Oberbegriff des Patentanspruchs 1.

Aus der Praxis ist ein derartiges Bestückungsgerät bekannt, dessen Werkzeug in Form einer Saugnadel ortsfest angeordnet ist, während sein Leiterplattenträger in Form eines Koordinatenschlittens in X- und Y-Richtung verfahren werden kann. Der Leiterplattenträger ist mit der Vorratseinrichtung kombiniert und nimmt infolgedessen außer der zu bestückenden Leiterplatte auch die zur Bestückung vorgesehenen Bauteile auf. Oberhalb des Werkzeuges ist außerdem ein Mikroskop ortsfest angeordnet, mittels welchem ein bestimmter Bereich um das zur Aufnahme der Bauteile vorgesehene freie Ende des Werkzeuges betrachtet werden kann.

Zum Bestücken der Leiterplatte wird der Leiterplattenträger in eine Ubergabeposition verfahren, in der das zur Bestückung vorgesehene Bauteil genau unterhalb des Werkzeuges in dessen Achse liegt. Sodann wird das Werkzeug abgesenkt, um das Bauteil vom Leiterplattenträger aufzunehmen, und anschließend wieder angehoben. Ein erneutes Verfahren des Leiterplattenträgers in eine Bestückungsposition bringt die zu bestückende Stelle auf der Leiterplatte genau unterhalb des Werkzeuges, so daß es in dessen Achse liegt. Nun wird das Werkzeug abgesenkt, um das Bauteil auf die Leiterplatte abzulegen, auf der es befestigt wird. Nach erneutem Anheben des Werkzeuges kann der Bestückungszyklus wieder beginnen.

Aus der Praxis ist ein weiteres Bestückungsgerät bekannt, dessen Leiterplattenträger ortsfest und dessen Werkzeug verfahrbar angeordnet ist. Der Bestückungsvorgang erfolgt mit diesem Gerät in der gleichen Aufeinanderfolge von Verfahrensschritten wie bei dem vorbeschriebenen Gerät, jedoch in kinematischer Umkehr zu diesem durch Verfahren des Werkzeuges statt des Leiterplattenträgers zwischen übernahmepositionen zur übernahme eines Bauteils von der Vorratseinrichtung und Bestückungspositionen zum Ablegen des Bauteils auf die Leiterplatte.

Die vorbeschriebenen bekannten Bestückungsgeräte sind demnach konstruktiv so ausgelegt, daß immer nur eine der beiden Baueinheiten ausgehend von einer vorausgehenden Bestückungsposition in eine übergabe- bzw. übernahmeposition und danach zurück in eine gegenüber der vorausgehenden Bestückungsposition geänderte nachfolgende Bestückungsposition verfährt. Diese Aufeinanderfolge von Verfahrbewegungen zwischen sich ständig ändernden Bestückungspositionen und übergabe- bzw. übernahmepositionen muß eingehalten werden und erfordert eine Indexiereinrichtung, falls eine solche zur genauen Festlegung der jeweils anzufahrenden Position verwendet wird, von relativ aufwendiger Konstruktion. Ferner sind die Wegstrecken zwischen den einzelnen Positionen unter entsprechendem Zeitaufwand von der jeweils verfahrbaren Baueinheit zurückzulegen.

Ein weiteres Bestückungsgerät ist aus dem Dokument EP-A 0 338 454 bekannt. Die Erfindung unterscheidet sich von dem vorbeschriebenen Stand der Technik durch die kennzeichnenden Merkmale des Patentanspruchs 1. Die einzelnen Verfahrbewegungen werden nun nicht von einer einzigen Baueinheit, sondern sowohl vom Werkzeug als auch vom Leiterplattenträger durchgeführt. Das Werkzeug fährt ausgehend von einer Garagenposition in eine Übernahmeposition und zurück in die unveränderliche Garagenposition, während zur gleichen Zeit der Leiterplattenträger von der vorhergehenden in die nächste Bestückungsposition fährt. Diese gleichzeitige Durchführung von Verfahrbewegungen entlang kürzerer Wege bedeutet eine Zeitersparnis. Die von der jeweiligen Übernahmeposition ausgehende Verfahrbewegung des Werkzeuges in die Garagenposition erfordert keine Indexierung. Der Leiterplattenträger legt zwischen den einzelnen Bestückungspositionen sehr kurze Wege zurück und kann somit sehr präzise gesteuert werden. Das erfindungsgemäße System ist sehr flexibel und ausbaufähig, da es sowohl manuell bedient als auch zum halbautomatischen Betrieb ausgebildet werden kann.

Vorzugsweise ist der Leiterplattenträger in den Bestückungspositionen, in die er mittels einer Antriebseinrichtung verfahrbar und in denen er arretierbar sein kann, mittels einer programmierbaren Indexiereinrichtung festlegbar.

Vorzugsweise ist wenigstens eine Übernahmeposition vorgesehen, in die das Werkzeug verfahrbar und in der es zwecks Übernahme der Bauteile von der Vorratseinrichtung in Z-Richtung bewegbar ist. Das Werkzeug kann in der Übernahmeposition arretierbar sein. vorteilhafterweise ist das Werkzeug mittels eines Antriebs in die Übernahmeposition verfahrbar und gemäß einer Weiterbildung der Erfindung bei Erreichen der Übernahmeposition automatisch in Z-Richtung bewegbar.

Vorzugsweise ist die Vorratseinrichtung in Übergabepositionen verfahrbar und arretierbar, in denen die zu übergebenden Bauteile auf das in der Übernahmeposition befindliche Werkzeug ausgerichtet sind. Dabei können die Übergabepositionen der Vorratseinrichtung mittels einer programmierbaren Indexiereinrichtung festlegbar sein. Gemäß einer Weiterbildung der Erfindung, ist die Vorratseinrichtung mittels eines Antriebs in die jeweilige Übergabeposition verfahrbar, in der sie außerdem arretiert werden kann.

Vorzugsweise ist die Vorratseinrichtung in einer Ebene oberhalb des Leiterplattenträgers angeordnet. Dabei kann sie in den Verfahrbereich des Leiterplattenträgers hineinragen, so daß die Wegstrecke zwischen der Garagenposition und der Übernahmeposition kurz ist und entsprechend schnell vom Werkzeug zurückgelegt werden kann. Vorteilhafterweise umfaßt die Vorratseinrichtung ein Transportband oder ein Magazin mit einem auswechselbaren drehbaren Drehteller. Es ist günstig, für die Vorratseinrichtung Behälter zur Aufnahme jeweils gleichartiger Bauteile vorzusehen.

Vorteilhafterweise ist eine in einer Ebene zwischen dem angehobenen und dem abgesenkten Werkzeug angeordnete Abdeckung für die Vorratseinrichtung und dem Leiterplatteträger mit je einer Zugangsöffnung für den Zugang des Werkzeuges zur Vorratseinrichtung und zum Leiterplattenträger vorgesehen. Die Abdeckung ist vorzugsweise entfernbar ausgebildet. Dabei kann die Abdeckung mehrteilig ausgebildet sein, wobei beide Zugangsöffnungen randoffen in einem Abdeckungsteil oder in mehreren Abdeckungsteilen angeordnet sind. Vorzugsweise umfaßt die Abdeckung wenigstens ein ortsfestes und wenigstens ein verschiebbares Abdeckungsteil.

Gemäß einer Weiterbildung der Erfindung ist ein Mikroskop vorgesehen, dessen Gesichtsfeld die zu bestückende Stelle auf der Leiterplatte umfaßt.

Die Werkzeug-Arretiereinrichtung kann einen ortsfesten Anschlag an einem Rahmenteil des Bestückungsgerätes und einen Gegenanschlag an einem am Rahmenteil verfahrbaren und das Werzeug tragenden Halterungsarm umfassen.

Gemäß einer vorteilhafteren Ausbildung umfaßt die Werkzeug-Arretiereinrichtung einen am Rahmenteil hin- und herbewegbar geführten Stift und eine im Halterungsarm ausgebildete Bohrung zur im wesentlichen spielfreien Aufnahme des Stiftes. Zur Erleichterung des Ausrichtens des Stiftes auf die Bohrung ist es günstig, wenn die Bohrung einen den Stift im wesentlichen spielfrei aufnehmenden inneren Bohrungsabschnitt und einen sich in Richtung zu diesem konisch verjüngenden äußeren Bohrungsabschnitt umfaßt, dessen größter Querschnitt einen Fangbereich zum Erfassen des Stiftes und Bewegen des Werkzeug-Halterungsarms bis zur Aufnahme des Stiftes im inneren Bohrungsabschnitt darstellt. Dabei kann der Stift am freien Ende des Kurbelarms einer durch einen Elektromotor antreibbaren Schubkurbel angelenkt sein. Günstig ist eine Ausbildung, gemäß welcher eine Sensorschaltung zum Erfassen der Totpunktlagen des Stiftes und zum Ausschalten des Elektromotors bei Erreichen dieser Totpunktlagen vorgesehen ist.

Gemäß einer weiteren alternativen Ausbildung umfaßt die Werkzeug-Arretiereinrichtung einen am Rahmenteil befestigten Elektromagneten und zwei am Halterungsarm befestigte Gegenpole, wobei ein Luftspalt zwischen den Polen des Elektromagneten und den Gegenpolen vorgesehen ist, der zusammen mit der Stärke des Elektromagneten einen Fangbereich für die Gegenpole darstellt.

Das Bestückungsgerät kann eine weitere zweite Sensorschaltung aufweisen, die einen am Rahmenteil befestigten Sensor und einen am Werkzeug-Halterungsarm befestigten Signalauslöser umfaßt und zum Einschalten des Elektromotors zwecks Absenken des Stiftes bzw. zum Einschalten des Elektromagneten vorgesehen ist, wenn der Sensor in den Bereich des Signalauslösers gelangt, wobei der Bereich des Signalauslösers im wesentlichen die gleiche Größe wie der Fangbereich des äußeren Bohrungsabschnitts bzw. des Elektromagneten aufweist.

Vorzugsweise umfaßt das Bestückungsgerät eine weitere dritte Sensorschaltung zum Erfassen der Aufwärtsbewegung des in der Garagenposition befindlichen Werkzeugs und zum Einschalten des Elektromotors zwecks Anheben des Stiftes bei Erfassen der Aufwärtsbewegung.

Nachstehend ist die Erfindung anhand eines bevorzugten Ausführungsbeispiels unter Bezugnahme auf die Zeichnung näher beschrieben. Es zeigen
- Fig. 1: eine perspektivische Darstellung des bevorzugten Ausführungsbeispiels des erfindungsgemäßen Bestückungsgeräts,
- Fig. 2: eine vergrößerte perspektivische Darstellung des Bestückungsgeräts nach Fig. 1 ohne Abdeckung und ohne Einzelheiten einer X- und Y-Führung eines Werkzeugs-Halterungsarms,
- Fig. 3: eine vergrößerte perspektivische Darstellung einer in Fig. 1 gezeigten Werkzeug-Arretiereinrichtung,
- Fig. 3a: eine vergrößerte Schnittdarstellung der Arretierelemente der Werkzeug-Arretiereinrichtung nach Fig. 3,
- Fig. 4: eine vergrößerte perspektivische Darstellung einer Werkzeug-Arretiereinrichtung gemäß einer zweiten Ausführungsform, und
- Fig. 5: eine vergrößerte perspektivische Darstellung einer Werkzeug-Arretiereinrichtung gemäß einer dritten Ausführungsform.

Das in der Zeichnung dargestellte Bestückungsgerät gemäß der Erfindung umfaßt einen Rahmen 1 mit einer Bodenplatte 2 und einem Rahmenteil 3, einen Leiterplattenträger 4 für eine mit Bauteilen 5, wie z.B. SMD-Bauteilen, zu bestückende Leiterplatte 6, eine Vorratseinrichtung 7 für die Bauteile 5, einen Werkzeug-Halterungsarm 8 mit einem Werkzeug 9 zum Übertragen der Bauteile 5 von der Vorratseinrichtung 7 auf die zu bestückende Leiterplatte 6 sowie eine Abdeckung 10 für den Leiterplattenträger 4 und die Vorratseinrichtung 7.

Der Rahmenteil 3 weist die Form einen U-förmigen Trägers auf, der mit seinen Schenkeln 11 im rückwärtigen Bereich der Bodenplatte 2 an dieser befestigt ist. Im vorderen Bereich der Bodenplatte 2 ist der Leiterplattenträger 4 in X- und Y-Koordinatenrichtungen verfahrbar angeordnet. Zu diesem Zweck sind an der Bodenplatte 2 zwei Führungsschienen 12 zur Führung eines Rahmens 13 in der X-Koordinatenrichtung befestigt. An den dem Rahmeninneren zugewandten Flächen der normal zu den Führungsschienen 12 verlaufenden Rahmenabschnitte 14 des Rahmens 13 sind in der Y-Koordinatenrichtung verlaufende Führungen 15 für den Leiterplattenträger 4 ausgebildet. Letzterer umfaßt eine plattenförmige Halterung 16 mit einer in der X-Koordinatenrichtung verlaufenden Nut 17 mit hinterschnittenem Querschnitt und zwei Schienen 18 mit je einer in Schienenlängsrichtung verlaufenden Aussparung zur Aufnahme einer Leiterplatte 6. Eine der Schienen 18 ist zur Anpassung des Leiterplattenträgers 4 an Leiterplatten 6 unterschiedlicher Größe entlang der Nut 17 verschiebbar angeordnet. Zu diesem Zweck weist diese Schiene 18 eine Zunge 19 auf, die mittels einer mit ihrem Schraubenkopf in der Nut 17 verschiebbar angeordneten Schraube 20 an der plattenförmigen Halterung 16 verspannbar ist.

Der Werkzeug-Halterungsarm 8 ist in X- und Y-Koordinatenrichtungen am Rahmenteil 3 verfahrbar gelagert. Zu diesem Zweck ist ein Führungsschlitten 21 mit vier Y-Führungsrollen 22 zur Führung des Werkzeug-Halterungsarms 8 in der Y-Koordinatenrichtung vorgesehen. Der Führungsschlitten 21 selbst ist mittels drei X-Führungsrollen 23 an je einer Führungsleiste 24, 25 an der Vorderseite bzw. Rückseite des querverlaufenden Steges 26 des Rahmenteils 3 in X-Koordinatenrichtung geführt. Die Führungsleiste 24 an der Vorderseite des Steges 26 weist einen runden Querschnitt auf und greift in eine der X-Führungsrollen 23 ein. Die Führungsleiste 25 an der Rückseite des Steges 26 ist von rechteckigem Querschnitt mit einer unteren und einer oberen Führungsfläche für die beiden verbleibenden X-Führungsrolle 23. Der Führungsschlitten 21 und die Führungsleiste 24 sind durch eine am Rahmenteil 3 befestigte Verkleidung 27 gegenüber dem vorderen Bereich des Bestückungsgerätes geschützt.

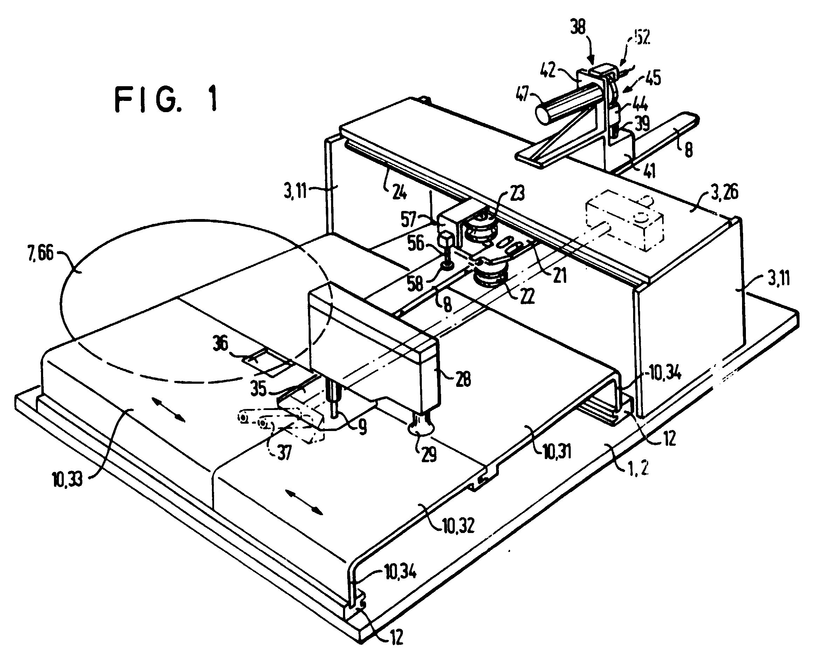

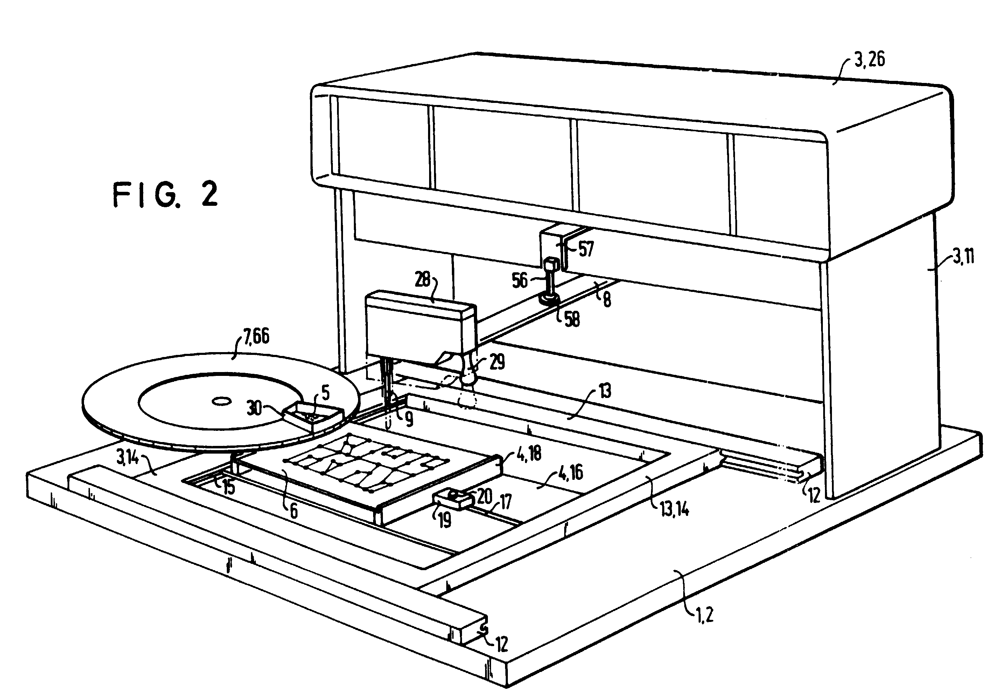

Das Werkzeug 9 ist als eine an eine Vakuumquelle anschließbare Saugnadel ausgebildet, wie sie üblicherweise bei der Bestückung von Leiterplatten Verwendung findet und aus diesem Grunde hier nicht näher beschrieben ist. Sie ragt an der Unterseite eines Werkzeugblockes 28 hervor, der am freien vorderen Ende des Werkzeug-Halterungsarms 8 vertikal bewegbar befestigt ist. Das Absenken des Werkzeugblockes 28 mit der Saugnadel 9 erfolgt manuell und das Anheben unter der Wirkung einer nicht gezeigten Federeinrichtung, die im Inneren des Werkzeugblocks 28 am Werkzeug-Halterungsarm 8 abgestützt ist. Am Werkzeugblock 28 ist ein Handgriff 29 angebracht, mit dem das Werkzeug 9 manuell zwischen Übernahmepositionen, in der es Bauteile 5 von der Vorratseinrichtung 7 übernimmt, und einer in den Fig. 1 und 2 gezeigten Garagenposition verfahren werden kann. In der Garagenposition ist der Werkzeug-Halterungsarm 8 und damit das Werkzeug 9 mittels einer Werkzeug-Arretiereinrichtung arretierbar. Die Garagenposition ist diejenige Position, in der das Werkzeug 9 abgesenkt wird, um das jeweilige, von der Vorratseinrichtung 7 übernommene Bauteil 5 auf die jeweils zu bestückende Stelle der Leiterplatte 6 abzulegen.

Die Vorratseinrichtung 7 ist als Magazin mit einem auswechselbaren Drehteller 66 ausgebildet, der in einer Ebene oberhalb und parallel zur Bewegungsebene des Leitenplattenträgers 4 sowie unterhalb und parallel zur Bewegungsebene des Werkzeugs 9, in den Verfahrbereich des Leiterplattenträgers 4 hineinragend, nahe der Garagenposition des Werkzeugs 9 angeordnet ist. Behälter 30 zur Aufnahme jeweils unterschiedlicher Bauteile 5 sind im äußeren Umfangsbereich der Vorratseinrichtung 7 auswechselbar befestigt.

Der Leitenplattenträger 4 und die Vorratseinrichtung 7 können mittels je einer nicht gezeigten Antriebseinrichtung und einer ebenfalls nicht gezeigten Indexiereinrichtung in die jeweils erforderlichen Bestückungspositionen bzw. Übergabepositionen mit nachfolgender Arretierung verfahren werden. In der jeweiligen Bestückungsposition ist die jeweils zu bestückende Stelle der Leiterplatte 6 auf das in der Garagenposition befindliche Werkzeug 9 ausgerichtet. In der jeweiligen Übernahmeposition befindet sich der Drehteller 66 in derjenigen Drehstellung, in welcher der die erforderlichen Bauteile 5 enthaltende Behälter 30 unterhalb der Zugangsöffnung 36 angeordnet ist. Die erforderlichen Bauteile 5 sind diejenigen, von denen eines oder mehrere zur Übernahme durch das Werkzeug 9 zwecks Bestückung der Leiterplatte 6 vorgesehen ist bzw. sind.

Die Abdeckung 10 ist in einer Ebene zwischen der angehobenen und der abgesenkten Stellung des Werkzeugs 9 angeordnet. Sie besteht aus drei Abdeckungsteilen 31, 32, 33, die als Ganzes die Form einer U-Schiene aufweisen, deren Schenkel 34 in Rinnen an der Oberseite der Führungsschienen 12 angeordnet sind. Die Abdeckungsteile 31, 32, 33 stützen sich zur Aufrechterhaltung als Ganzes mit ihrer einander zugewandten, in X-Koordinatenrichtung verlaufenden Stirnflächen einander mittels einer in diesen Stirnflächen ausgebildeten Nut/Feder-Anordnung ab. Der rückwärtige Abdeckungsteil 31 ist ortsfest, während die beiden vorderen Abdeckungsteile 32, 33 in X-Koordinatenrichtung verschiebbar sind, wobei die nicht gezeigte Nut/Federanordnung in ihren Stirnflächen und die Rinne in der vorderen Führungsschiene 12 zur Führung dienen. Je eine Aussparung in den einander und dem rückwärtigen Abdeckungsteil zugewandten Eckbereichen der vorderen Abdeckungsteile 32, 33 bilden eine Zugangsöffnung 35 für das Werkzeug 9 zur Leiterplatte 6. Eine weitere Zugangsöffnung 36 für das Werkzeug 9 zur Vorratseinrichtung 7 ist randoffen in dem dem rückwärtigen Abdeckungsteil 31 zugewandten Randbereich des vorderen Abdeckungsteils 33 ausgebildet.

Ein Mikroskop 37 ist mittels eines Armes schwenkbar am querverlaufenden Steg 26 des Rahmenteils 3 angebracht. Das Gesichtsfeld des Mikroskops 37 umfaßt die jeweils zu bestückende Stelle auf der Leiterplatte 6.

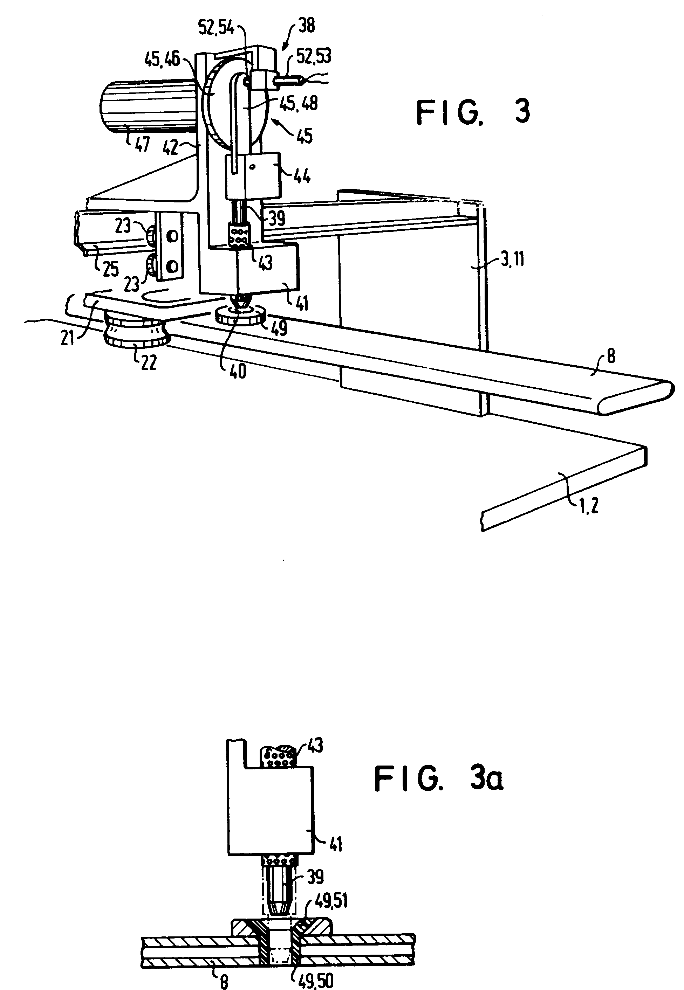

Die in Fig. 3 gezeigte Werkzeug-Arretiereinrichtung 38 umfaßt einen am Rahmenteil 3 auf- und abbewegbaren Stift 39 und eine im rückwärtigen Bereich des Werkzeug-Halterungsarms 8 ausgebildete Durchgangsbohrung zur im wesentlichen spielfreien Aufnahme des Stiftes 39. Letzterer ist in einer Bohrung in einem Führungsblock 41 eines am Steg 26 des Rahmenteils 3 befestigten Winkelträgers 42 mittels einer Kugellageranordnung geführt, die in einer den Stift 39 umgebenden Hülse 43 ausgebildet ist. Zum Anheben und Absenken des Stiftes 39 ist eine Schubkurbel 45 vorgesehen, deren Kurbelscheibe 46 von einem am Winkelträger 42 befestigten Elektromotor 47 antreibbar ist. Innerhalb eines Verbindungsstücks 44 ist das obere Ende des Stiftes 39 an das freie Ende des Kurbelarms 48 der Schubkurbel 45 angelenkt.

Die Durchgangsbohrung 40 ist in einem den Werkzeug-Halterungsarm 8 durchsetzenden Einsatz 49 ausgebildet. Sie umfaßt einen inneren Bohrungsabschnitt 50 zur im wesentlichen spielfreien Aufnahme des Stiftes 39 und einen äußeren Bohrungsabschnitt 51, der sich in Richtung zum inneren Bohrungsabschnitt 50 verjüngt und dessen größter Querschnitt einen Fangbereich zum Erfassen des Stiftes 39 und Bewegen des Werkzeug-Halterungsarms 8 bis zur Aufnahme des Stiftes 39 im inneren Bohrungsabschnitt 50 darstellt. Das untere Ende des Stiftes 39 ist konisch angefast.

Das erfindungsgemäße Bestückungsgerät umfaßt eine Sensorschaltung 52 mit zwei induktiven Näherungsschaltern zum Erfassen der unteren und der oberen Totpunktlage des Stiftes 39 und zum Ausschalten des Elektromotors 47 jedesmal dann, wenn der Stift 39 eine dieser Totpunktlagen erreicht. Der induktive Näherungsschalter zum Erfassen der oberen Totpunktlage des Stiftes 39 ist in Fig. 3 dargestellt und umfaßt einen Sensor 53 und einen Signalauslöser 54 in Form eines Weicheisenplättchens. Letzterer ist im Anlenkpunkt des Kurbelarms 48 an der Kurbelscheibe 46 und ersterer am Winkelträger 42 befestigt. Der nicht gezeigte induktive Näherungsschalter zum Erfassen der unteren Totpunktlage des Stiftes 39 umfaßt ebenfalls einen Sensor und einen Signalauslöser in Form eines Weicheisenplättchens, die beide durch die Kurbelscheibe 46 verdeckt sind. Der Signalauslöser dieses induktiven Näherungsschalters ist gegenüber dem erstgenannten Signalauslöser 54 um 180° versetzt an der nicht sichtbaren Rückseite der Kurbelscheibe 46 befestigt. Entsprechend ist der zugeordnete Sensor am Winkelträger 42 befestigt.

Das erfindungsgemäße Bestückungsgerät umfaßt eine weitere zweite Sensorschaltung 55 mit einem induktiven Näherungsschalter, der ebenfalls einen Sensor und einen Signalauslöser umfaßt. Der hier mit den Bezugszeichen 56 bezeichnete Sensor ist über ein Winkeleisen 57 an der Vorderseite des querverlaufenden Steges 26 vor der Verkleidung 27 (s. Fig. 2) befestigt. Der hier mit dem Bezugszeichen 58 bezeichnete Signalauslöser in Form eines kreisrunden Weicheisenplättchens ist am Werkzeug-Halterungsarm 8 in dessen vorderen Bereich befestigt. Sein Durchmesser ist größer als derjenige des Sensors 56 und entspricht im wesentlichen dem größten Durchmesser des äußeren Bohrungsabschnittes 51 der Durchgangsbohrung 40. Der Sensor 56 und der Signalauslöser 58 weisen gleiche Abstände zum Stift 39 und der Durchgangsbohrung 40 der Werzeug-Arretiereinrichtung 38 auf.

Weiterhin ist eine hier nicht gezeigte weitere dritte Sensorschaltung zum Erfassen der Aufwärtsbewegung des in der Garagenposition und/oder der Übernahmeposition befindlichen Werkzeugs 9 und zum Einschalten des Elektromotors 47 zwecks Anheben des Stiftes 39 und/oder zum Einschalten des Antriebs der Vorratseinrichtung 7 bei Erfassen der Aufwärtsbewegung vorgesehen.

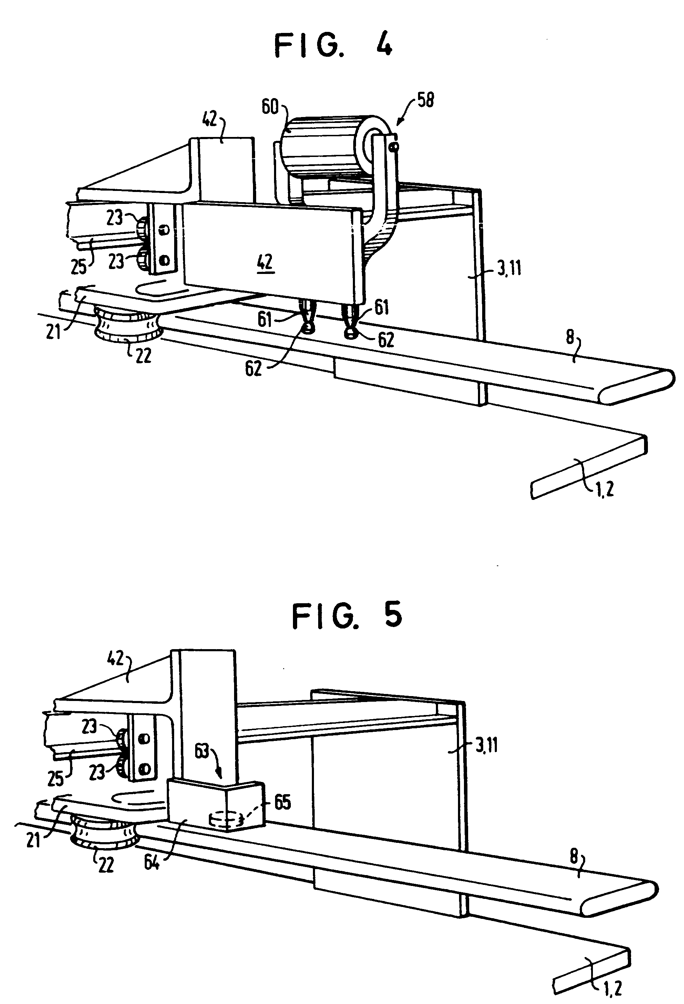

Eine alternative Ausführung der Werkzeug-Arretiereinrichtung ist in Fig. 4 gezeigt und dort mit dem Bezugszeichen 59 bezeichnet. Sie umfaßt einen am Winkelträger 42 befestigten Elektromagneten 60 mit zwei Polen 61 und zwei im rückwärtigen Bereich des Werkzeugs-Halterungsarms 8 befestigte Gegenpole 62. Letztere sind entgegengesetzt zum jeweils zugeordneten Pol 61 gepolt. Wie in Fig. 4 gezeigt, ist zwischen den Polen 61 und den Gegenpolen 62, wenn diese einander gegenüberstehen, ein Luftspalt vorgesehen, der zusammen mit der Stärke des Elektromagneten 60 einen Fangbereich für die Gegenpole 62 darstellt. Zum Einschalten des Elektromagneten 60 ist die weitere Sensorschaltung 55 vorgesehen, deren Sensor 56 und Signalauslöser 58 gleiche Abstände von den Polen 61 und den Gegenpolen 62 aufweisen.

Eine weitere alternative Ausführung der Werkzeug-Arretiereinrichtung ist in Fig. 5 dargestellt und mit den Bezugszeichen 63 bezeichnet. Diese Arretiereinrichtung umfaßt einen am Winkelträger 42 befestigten rechtwinkligen Anschlag 64 und einen im rückwärtigen Bereich des Werkzeug-Halterungsarms 8 befestigten Gegenanschlag 65. Letzterer ist dazu vorgesehen, in den von den Schenkeln des rechtwinkligen Anschlags 64 umschriebenen Raum bis zur Anlage an diese Schenkel einzutreten.

Die Funktion des erfindungsgemäßen Bestückungsgeräts ist nachstehend unter Berücksichtigung der in Fig. 3 dargestellten Werkzeug-Arretiereinrichtung 38 beschrieben:
Als erstes wird eine zu bestückende Leiterplatte 6 zwischen den Schienen 18 des Leiterplattenträgers 4 unter Verwendung der Schraube 20 eingespannt. Ein Drehteller 66, dessen Behälter 30 mit den zur Bestückung der Leiterplatte 6 erforderlichen Bauteilen 5, nach Art getrennt, gefüllt sind, wird in die Vorratseinrichtung 7 eingesetzt. Deren Indexiereinrichtung wird so programmiert, daß sich der Drehteller 66 während der Übernahme eines Bauteils 5 durch das Werkzeug 9 in der Ubergabeposition befindet, in der derjenige Behälter 30, der die für den jeweiligen Bestückungsvorgang erforderlichen Bauteile 5 enthält, unterhalb der Zugangsöffnung 36 angeordnet ist. Abschließend werden die Abdeckungsteile 31, 32, 33 in die in Fig. 1 gezeigte Stellung gebracht, um dem Leiterplattenträger 4 und mit der Leiterplatte 6 und den beschickten Drehteller 66 abzudecken.

Zum Bestücken der Leiterplatte 6 wird das Werkzeug 9 mittels des Handgriffs 29 manuell von der in Fig. 1 gezeigten Garagenposition in eine Übernahmeposition verfahren, in der es im Bereich der Zugangsöffnung 36 angeordnet ist. Der Drehteller 66 ist durch den Antrieb in die erforderliche Übergabeposition gedreht. Durch manuell auf den Werkzeugblock 28 ausgeübten Druck wird das Werkzeug 9 durch die Zugangsöffnung 36 hindurch abgesenkt, bis es auf eines der erforderlichen Bauteile 5 in dem unterhalb der Zugangsöffnung 36 befindlichen Behälter 30 des Drehtellers 66 auftrifft und durch Unterdruck erfaßt. Der Werkzeugblock 28 wird bei entsprechender Reduzierung des auf ihn manuell ausgeübten Druckes zusammen mit dem Werkzeug 9 und dem Bauteil 5 unter der Wirkung der elastischen Rückstellkräfte der Feder im Inneren des Werkzeugblockes 28 in die angehobene Position zurückbewegt. Mittels der dritten Sensorschaltung wird diese Bewegung des Werkzeuges 9 erfaßt und der Antrieb der Vorratseinrichtung 7, falls erforderlich, eingeschaltet, um den Drehteller 66 in die nächste Übergabeposition zu verfahren.

Das Werkzeug 9 wird nun mittels des Handgriffes 29 manuell in die Garagenposition verfahren, bei deren Erreichen der Signalauslöser 58 auf dem und der äußere Bohrungsabschnitt 51 der Bohrung 40 im Werkzeug-Halterungsarm 8 unterhalb des am Rahmenteil 3 befestigten Sensors 56 bzw. des sich in der oberen Totpunktlage befindlichen Stiftes 39 der Werkzeug-Arretiereinrichtung 38 angeordnet sind. Die Sensorschaltung 55 schaltet nun in Reaktion auf das vom Signalauslöser 58 im Sensor 56 ausgelöste Signal den Elektromotor 47 ein, so daß der Stift 39 abgesenkt wird. Aufgrund der im Vergleich zu den Querschnittsflächen des Sensors 56 und des Stiftes 39 größeren Querschnittsflächen des Signalauslösers 58 und des äußeren Bohrungsabschnittes 51 ist eine koaxiale Anordnung dieser vier Bauteile 39, 51 bzw. 56, 58 nicht erforderlich. Bei nicht koaxialer Anordnung gelangt der sich absenkende Stift 39 in Kontakt mit der konischen Wandfläche des äußeren Bohrungsabschnittes 51 und verschiebt den Werkzeug-Halterungsarm 8 so, daß er koaxial zum inneren Bohrungsabschnitt 50 angeordnet ist und folglich in diesen eintreten kann, um bei Erreichen seiner unteren Totpunktlage den Werkzeug-Halterungsarm 8 in der Garagenposition zu arretieren. In der unteren Totpunktlage des Stiftes 39 liegt der Signalauslöser 54 der Sensorschaltung 52 gegenüber dem Sensor 53 und löst in diesem ein Signal aus. In Reaktion auf dieses Signal schaltet die Sensorschaltung 52 den Elektromotor 47 aus, so daß der Stift 39 in der unteren Totpunktlage verbleibt.

Das Werkzeug 9 befindet sich in der Garagenposition über der Zugangsöffnung 35 und über der bereits mittels der Antriebseinrichtung des Leiterplattenträgers 4 in die Bestückungsposition unterhalb der Zugangsöffnung 35 verfahrenen Leiterplatte 6. Nun wird durch manuell auf den Werkzeugblock 28 ausgeübten Druck das Werkzeug 9 mit dem Bauteil 5 durch die Zugangsöffnung 35 hindurch abgesenkt, bis das Bauteil 5 auf die zu bestückende Stelle auftrifft und durch automatische Aufhebung des Unterdrucks auf diese Stelle zwecks Befestigung abgesetzt wird. Der Werkzeugblock 28 wird nun bei entsprechender Reduzierung des auf ihn manuell ausgeübten Druckes zusammen mit dem Werkzeug 9 unter der Wirkung der elastischen Rückstellkräfte der Feder im Inneren des Werkzeugblockes 28 in die angehobene Stellung zurückbewegt. Die nicht dargestellte dritte Sensorschaltung erfaßt diese Bewegung des Werkzeugs 9 und schaltet in Reaktion auf diese den Elektromotor 47 ein, um den Stift 39 bis in seine obere Totpunktlage zu verfahren und auf diese Weise die Werkzeug-Arretiereinrichtung 38 zu entsperren. Bei Erreichen der oberen Totpunktlage schaltet die Sensorschaltung 52 den Elektromotor 47 aus, so daß der Stift 39 in dieser oberen Totpunktlage verbleibt. Die dritte Sensorschaltung wird außerdem dazu benutzt, bei Erfassen der Aufwärtsbewegung des in der Garagenposition befindlichen Werkzeuges 9 in die angehobene Stellung die Antriebseinrichtung des Leiterplattenträgers 4 einzuschalten, um diesen in die nächste Bestückungsposition zu verfahren und dort mittels der Indexiereinrichtung festzulegen.

Nun kann durch erneutes Verfahren des Werkzeuges 9 von der Garagenposition in die Übernahmeposition der nächste Bestückungsvorgang beginnen.

Der Leiterplattenträger 4 wird, falls ihm keine Antriebseinrichtung zugeordnet ist, manuell verfahren, wobei der linke vordere Abdeckungsteil 33 entfernt wird, um den Zugang zur Handhabung des Leiterplattenträgers 4 zu ermöglichen. Gleichzeitig wird vorzugsweise das Mikroskop 37 verwendet, um erforderlichenfalls den Leiterplattenträger 4 genau in die Bestückungsposition einstellen zu können.

Im vorliegenden Ausführungsbeispiel ist die Z-Richtung als vertikale Richtung mit dazu normal verlaufenden X- und Y-Richtungen beschrieben. Das Bestückungsgerät oder das Werkzeug kann aber auch räumlich so angeordnet sein, daß die Z-Richtung in jedem beliebigen Winkel zur Horizontalen verläuft. Ferner kann die Z-Richtung auch in einem vom rechten Winkel abweichenden Winkel zu den X-Y-Richtungen angeordnet sein.

## Patentansprüche

1. Bestückungsgerät zum Bestücken von Leiterplatten mit Bauteilen, mit
- einer Vorratseinrichtung für die Bauteile,
- mit einer ersten Baueinheit (4 bis 9) in Form eines Leiterplattenträgers zum Halten wenigstens einer Leiterplatte (6)
- und mit einer in einer Ebene oberhalb der Vorratseinrichtung (7) und des Leiterplattenträgers angeordneten zweiten Baueinheit (28) in Form eines in Z-Richtung bewegbaren Werkzeuges (9) zum Übertragen der Bauteile von der Vorratseinrichtung (7) auf die im Leiterplattenträger befindliche Leiterplatte (6),
- wobei eine der beiden Baueinheiten in einer X-Y-Ebene gegenüber der jeweils anderen Baueinheit verfahrbar und mittels einer Werkzeug-Arretiereinrichtung (38, 59, 63) arretierbar ist,
**dadurch gekennzeichnet**,
daß zusätzlich die jeweils andere Baueinheit (4 bzw. 9) in einer X-Y-Ebene verfahrbar und das Werkzeug (9) zwecks Absetzen der aus der Vorratseinrichtung (7) entnommenen Bauteile (5) auf die Leiterplatte (6) mittels der Werkzeug-Arretiereinrichtung (38, 59, 63) in einer vorbestimmten Garagenposition arretierbar ist.

2. Bestückungsgerät nach Anspruch 1,
dadurch **gekennzeichnet**,
daß der Leiterplattenträger (4) in zwei Koordinatenrichtungen (X, Y) verfahrbar ist.

3. Bestückungsgerät nach Anspruch 1 oder 2,
dadurch **gekennzeichnet**,
daß der Leiterplattenträger (4) in Bestückungspositionen arretierbar ist, in denen die jeweils zu bestückende Stelle auf der Leiterplatte (6) auf das in der Garagenposition befindliche Werkzeug (9) ausgerichtet ist.

4. Bestückungsgerät nach Anspruch 3,
dadurch **gekennzeichnet**,
daß die Bestückungspositionen des Leiterplattenträgers (4) mittels einer programmierbaren Indexiereinrichtung festlegbar sind.

5. Bestückungsgerät nach Anspruch 3 oder 4,
dadurch **gekennzeichnet**,
daß der Leiterplattenträger (4) mittels einer Antriebseinrichtung in die Bestückungspositionen verfahrbar ist.

6. Bestückungsgerät nach wenigstens einem der vorhergehenden Ansprüche,
dadurch **gekennzeichnet**,
daß das Werkzeug (9) in zwei Koordinatenrichtungen (X, Y) verfahrbar ist.

7. Bestückungsgerät nach wenigstens einem der vorhergehenden Ansprüche,
**gekennzeichnet** durch
wenigstens eine Übernahmeposition, in die das Werkzeug (9) verfahrbar und in der es zwecks Übernahme der Bauteile (5) von der Vorratseinrichtung (7) in Z-Richtung bewegbar ist.

8. Bestückungsgerät nach Anspruch 7,
dadurch **gekennzeichnet**,
daß das Werkzeug (9) in der Übernahmeposition arretierbar ist.

9. Bestückungsgerät nach Anspruch 7 oder 8,
dadurch **gekennzeichnet**,
daß das Werkzeug (9) mittels eines Antriebs in die Übernahmeposition verfahrbar ist.

10. Bestückungsgerät nach wenigstens einem der Ansprüche 7 bis 9,
dadurch **gekennzeichnet**,
daß das Werkzeug (9) bei Erreichen der Übernahmeposition automatisch in Z-Richtung bewegbar ist.

11. Bestückungsgerät nach wenigstens einem der vorhergehenden Ansprüche,
dadurch **gekennzeichnet**
daß die Vorratseinrichtung (7) in Übergabepositionen verfahrbar ist, in denen die zu übergebenden Bauteile (5) auf das in der Übernahmeposition befindliche Werkzeug (9) ausgerichtet sind.

12. Bestückungsgerät nach Anspruch 11,
dadurch **gekennzeichnet**,
daß die Vorratseinrichtung (7) in den Übergabepositionen arretierbar ist.

13. Bestückungsgerät nach Anspruch 11 oder 12,
dadurch **gekennzeichnet**,
daß die Übergabepositionen der Vorratseinrichtung (7) mittels einer programmierbaren Indexiereinrichtung festlegbar sind.

14. Bestückungsgerät nach wenigstens einem der Ansprüche 11 bis 13,
dadurch **gekennzeichnet**,
daß die Vorratseinrichtung (7) mittels eines Antriebs in die Übergabepositionen verfahrbar ist.

15. Bestückungsgerät nach wenigstens einem der vorhergehenden Ansprüche,
dadurch **gekennzeichnet**,
daß die Vorratseinrichtung (7) in einer Ebene oberhalb des Leiterplattenträgers (4) angeordnet ist.

16. Bestückungsgerät nach Anspruch 15,
dadurch **gekennzeichnet**,
daß die Vorratseinrichtung (7) in den Verfahrbereich des Leiterplattenträgers (4) hineinragt.

17. Bestückungsgerät nach wenigstens einem der vorhergehenden Ansprüche,
dadurch **gekennzeichnet**,
daß für die Vorratseinrichtung (7) Behälter (30) zur Aufnahme jeweils gleichartiger Bauteile (5) vorgesehen sind

18. Bestückungsgerät nach wenigstens einem der vorhergehenden Ansprüche,
dadurch **gekennzeichnet**,
daß die Vorratseinrichtung (7) ein Transportband oder ein Magazin mit einem auswechselbaren drehbaren Drehteller (66) umfaßt.

19. Bestückungsgerät nach wenigstens einem der vorhergehenden Ansprüche,
**gekennzeichnet** durch
eine in einer Ebene zwischen dem angehobenen und dem abgesenkten Werkzeug (9) angeordneten Abdeckung (10) für die Vorratseinrichtung (7) und den Leiterplattenträger (4) mit je einer Zugangsöffnung (35, 36) für den Zugang des Werkzeuges (9) zum Leiterplattenträger (4) bzw. zur Vorratseinrichtung (7).

20. Bestückungsgerät nach Anspruch 19,
dadurch **gekennzeichnet**,
daß die Abdeckung (10) entfernbar ausgebildet ist.

21. Bestückungsgerät nach Anspruch 19 oder 20,
dadurch **gekennzeichnet**,
daß die Abdeckung (10) mehrteilig (31, 32, 33) ausgebildet ist und beide Zugangsöffnungen (35, 36) randoffen in einem Abdeckungsteil (33) oder mehreren Abdeckungsteilen (32, 33) angeordnet sind.

22. Bestückungsgerät nach Anspruch 21,
dadurch **gekennzeichnet**,
daß die Abdeckung (10) wenigstens ein ortsfestes (31) und wenigstens ein verschiebbares Abdeckungsteil (32, 33) umfaßt.

23. Bestückungsgerät nach wenigstens einem der vorhergehenden Ansprüche,
**gekennzeichnet** durch
ein Mikroskop (37), dessen Gesichtsfeld die zu bestückende Stelle auf der Leiterplatte (6) umfaßt.

24. Bestückungsgerät nach wenigstens einem der vorhergehenden Ansprüche,
dadurch **gekennzeichnet**,
daß die Werkzeug-Arretiereinrichtung (63) einen ortsfesten Anschlag (64) an einem Rahmenteil (3) des Bestückungsgeräts und einen Gegenanschlag (65) an einem am Rahmenteil (3) verfahrbaren, das Werkzeug (9) tragenden Werkzeug-Halterungsarm (8) umfaßt.

25. Bestückungsgerät nach wenigstens einem der Ansprüche 1 bis 23,
dadurch **gekennzeichnet**,
daß die Werkzeug-Arretiereinrichtung (38) einen am Rahmenteil (3) hin- und herbewegbar geführten Stift (39) und eine im Halterungsarm (8) ausgebildete Bohrung (40) zur im wesentlichen spielfreien Aufnahme des Stiftes (39) umfaßt.

26. Bestückungsgerät nach Anspruch 25,
dadurch **gekennzeichnet**,
daß die Bohrung (40) einen inneren Bohrungsabschnitt (50) zur im wesentlichen spielfreien Aufnahme des Stiftes (39) und einen sich zum inneren Bohrungsabschnitt (50) konisch verjüngenden äußeren Bohrungsabschnitt (51) umfaßt, dessen größter Querschnitt einen Fangbereich zum Erfassen des Stiftes (39) und Bewegen des Werkzeug-Halterungsarms (8) bis zur Aufnahme des Stiftes (39) im inneren Bohrungsabschnitt (50) darstellt.

27. Bestückungsgerät nach Anspruch 25 oder 26,
dadurch **gekennzeichnet**,
daß der Stift (39) am freien Ende des Kurbelarms (48) einer durch einen Elektromotor (47) antreibbaren Schubkurbel (45) angelenkt ist.

28. Bestückungsgerät nach Anspruch 27,
**gekennzeichnet** durch
eine Sensorschaltung (52) zum Erfassen der Totpunktlagen des Stiftes (39) und zum Ausschalten des Elektromotors (47) bei Erreichen dieser Totpunktlagen.

29. Bestückungsgerät nach wenigstens einem der Ansprüche 1 bis 23,
dadurch **gekennzeichnet**,
daß die Werkzeug-Arretiereinrichtung (59) einen am Rahmenteil (3) befestigten Elektromagneten (60) und zwei am Werkzeug-Halterungsarm (8) befestigte Gegenpole (62) umfaßt, wobei ein Luftspalt zwischen den Polen (61) des Elektromagneten (60) und den Gegenpolen (62) vorgesehen ist, der zusammen mit der Stärke des Elektromagneten (60) einen Fangbereich für die Gegenpole (62) definiert.

30. Bestückungsgerät nach wenigstens einem der Ansprüche 26 bis 29,
**gekennzeichnet** durch
eine weitere zweite Sensorschaltung (55), die einen am Rahmenteil (3) befestigten Sensor (56) und einen am Werkzeug-Halterungsarm (8) befestigten Signalauslöser (58) aufweist und zum Einschalten des Elektromotors (47) zwecks Absenken des Stiftes (39) bzw. zum Einschalten des Elektromagneten (60) vorgesehen ist, wenn der Sensor (56) in den Bereich des Signalauslösers (58) gelangt, wobei der Signalauslöserbereich (58) im wesentlichen die gleiche Größe wie der Fangbereich des äußeren Bohrungsabschnittes (51) bzw. des Elektromagneten (60) aufweist.

31. Bestückungsgerät nach wenigstens einem der Ansprüche 27 bis 30,
**gekennzeichnet** durch
eine weitere dritte Sensorschaltung zum Erfassen der Aufwärtsbewegung des in der Garagenposition und/oder der Übernahmeposition befindlichen Werkzeugs (9) und zum Einschalten des Elektromotors (47) zwecks Anheben des Stiftes (39) und/oder zum Einschalten des Antriebs der Vorratseinrichtung (7) bei Erfassen der Aufwärtsbewegung.

## Claims

1. A mounting device for mounting components on printed circuit boards, having
- a supply means for the components,
- having a first unit (4 to 9) in the form of a printed circuit board carrier for holding at least one printed circuit board (6)
- and having a second unit (28), arranged in a plane above the supply means (7) and above the printed circuit board carrier, in the form of a tool (9) movable in the Z-direction to transfer the components from the supply means (7) to the printed circuit board (6) located in the printed circuit board carrier,
- whereby one of the two units can be moved in an X-Y-plane relative to the other of the two units and can be arrested by means of a tool arresting device (38, 59, 63),
characterised in that,
in addition the other unit (4 or 9) can be moved in an X-Y-plane and the tool (9) can be arrested in a predetermined parking position by means of the tool-arresting device (38, 59, 63) for the purpose of depositing the component (5) taken from the supply means (7) on the printed circuit board (6).

2. A mounting device according to claim 1,
characterised in that,
the printed circuit board carrier (4) can be moved in two coordinate directions (X, Y).

3. A mounting device according to claim 1 or 2,
characterised in that,
the printed circuit board carrier (4) can be arrested in mounting positions in which the respective point on the printed circuit board (6) at which mounting is to take place is aligned with the tool (9) located in the parking position.

4. A mounting device according to claim 3,
characterised in that,
the mounting positions of the printed circuit board carrier (4) can be determined by means of a programmable indexing device.

5. A mounting device according to claim 3 or 4,
characterised in that,
the printed circuit board carrier (4) can be moved into the mounting positions by means of a drive.

6. A mounting device according to any preceding claim,
characterised in that,
the tool (9) can be moved in two coordinate directions (X, Y).

7. A mounting device according to any preceding claim,
characterised by
at least one pick-up position into which the tool (9) can be moved and in which it can be moved in the Z-direction to pick up the components (5) from the supply means (7).

8. A mounting device according to claim 7,
characterised in that,
the tool (9) can be arrested in the pick-up position.

9. A mounting device according to claim 7 or 8,
characterised in that,
the tool (9) can be moved into the pick-up position by means of a drive.

10. A mounting device according to any of claims 7 to 9,
characterised in that,
the tool (9) can be moved automatically in the Z-direction on reaching the pick-up position.

11. A mounting device according to any preceding claim,
characterised in that,
the supply means (7) can be moved into delivery positions in which the components (5) to be delivered are aligned with the tool (9) located in the pick-up position.

12. A mounting device according to claim 11,
characterised in that,
the supply means (7) can be arrested in the delivery positions.

13. A mounting device according to claim 11 or 12,
characterised in that,
the delivery positions of the supply means (7) can be determined by means of a programmable indexing device.

14. A mounting device according to any of claims 11 to 13,
characterised in that,
the supply means (7) can be moved into the delivery positions by means of a drive.

15. A mounting device according to any preceding claim,
characterised in that,
the supply means (7) is arranged in a plane above the printed circuit board carrier (4).

16. A mounting device according to claim 15,
characterised in that,
the supply means (7) projects into the field of movement of the printed circuit board carrier (4).

17. A mounting device according to any preceding claim,
characterised in that,
there are provided for the supply means (7) containers (30) to accommodate in each case components (5) of the same kind.

18. A mounting device according to any preceding claim,
characterised in that,
the supply means (7) includes a conveyor belt or a magazine with an exchangeable rotatable turntable (66).

19. A mounting device according to any preceding claim,
characterised by
a cover (10) for the supply means (7) and the printed circuit board carrier (4), arranged in a plane between the raised and the lowered tool (9) positions and having respective access openings (35, 36) for the tool (9) to access the printed circuit board carrier (4) and the supply means (7).

20. A mounting device according to claim 19,
characterised in that,
the cover (10) is removable.

21. A mounting device according to claim 19 or 20,
characterised in that,
the cover (10) has a plurality of parts (31, 32, 33) and the two access openings (35, 36) are arranged, open at the edges, in one cover part (33) or more than one cover part (32, 33).

22. A mounting device according to claim 21,
characterised in that,
the cover (10) includes at least one stationary cover part (31) and at least one displaceable cover part (32, 33).

23. A mounting device according to any preceding claim,
characterised by
a microscope (37) whose field of view includes the point on the printed circuit board (6) at which mounting is to take place.

24. A mounting device according to any preceding claim,
characterised in that,
the tool-arresting device (63) includes a fixed stop (64) on a frame part (3) of the mounting device and a counterstop (65) on a tool-supporting arm (8) that carries the tool (9) and is moveable on the frame part (3).

25. A mounting device according to any of claims 1 to 23,
characterised in that,
the tool-arresting device (38) includes a pin (39) guided to reciprocate back and forth on the frame part (3) and a bore (40) formed in the supporting arm (8) to accommodate the pin (39) with substantially no play.

26. A mounting device according to claim 25,
characterised in that,
the bore (40) includes an inner bore section (50) for accommodating the pin (39) with substantially no play, and an outer bore section (51), conically tapering towards the inner bore section (50), of which the largest cross-section forms a capture region for catching the pin (39) and for moving the tool-supporting arm (8) until the pin (39) is accommodated in the inner bore section (50).

27. A mounting device according to claim 25 or 26,
characterised in that,
the pin (39) is coupled to the free end of the crank arm (48) of a thrust crank (45), operable by an electric motor (47).

28. A mounting device according to claim 27,
characterised by
a sensor circuit (52) to detect the dead centre positions of the pin (39) and to switch off the electric motor (47) on reaching these dead centre positions.

29. A mounting device according to any of claims 1 to 23,
characterised in that,
the tool-arresting device (59) includes an electromagnet (60) fixed to the frame part (3) and two counter-poles (62) fixed to the tool-supporting arm (8), there being an air gap provided between the poles (61) of the electromagnet (60) and the counter-poles (62) which together with the strength of the electromagnet (60) defines a capture region for the counter-poles (62).

30. A mounting device according to any of claims 26 to 29,
characterised by
a further second sensor circuit (55) which includes a sensor (56) fixed to the frame part (3) and a signal generator (58) fixed to the tool-supporting arm (8) and is provided for switching on the electric motor (47) for the purpose of lowering the pin (39) or to switch on the electromagnet (60) when the sensor (56) reaches the region of the signal generator (58), the signal generator region (58) having substantially the same size as the capture region of the outer bore section (51) or of the electromagnet (60).

31. A mounting device according to any of claims 27 to 30,
characterised by
a further third sensor circuit to detect the upward movement of the tool (9) located in the parking position and/or in the pick-up position and to switch on the electric motor (47) for the purpose of lifting the pin (39) and/or to switch on the drive of the supply means (7) on detection of the upward movement.

## Revendications

1. Appareil pour mettre en place les composants sur des cartes à circuit imprimé comportant
- un dispositif de stockage pour les composants,
- un premier ensemble (4 à 9) qui se présente sous la forme d'un support de carte à circuit imprimé pour tenir au moins une carte à circuit imprimé (6),
- un second ensemble (28) qui est disposé dans un plan au-dessus du dispositif de stockage (7) et du support de carte à circuit imprimé et se présente sous la forme d'un outil (9) pouvant être déplacé dans la direction Z pour transférer les composants du dispositif de stockage (7) sur la carte à circuit imprimé (6) placée sur le support de carte à circuit imprimé, l'un des deux ensembles pouvant être déplacé dans un plan X-Y par rapport à l'autre ensemble et immobilisé au moyen d'un dispositif d'immobilisation d'outil (38, 59, 63),
caractérisé par le fait
que l'autre ensemble (4 ou 9) peut en outre être déplacé dans un plan X-Y et que l'outil (9) peut être immobilisé dans une position d'attente prédéterminée au moyen du dispositif d'immobilisation d'outil (38, 59, 63) aux fins de déposer sur la carte à circuit imprimé (6) les composants (5) prélevés dans le dispositif de stockage (7).

2. Appareil pour mettre en place les composants selon la revendication 1, caractérisé par le fait que le support (4) de carte à circuit imprimé peut être déplacé dans deux directions (X, Y).

3. Appareil pour mettre en place les composants selon la revendication 1 ou la revendication 2, caractérisé par le fait que le support (4) de carte à circuit imprimé peut être immobilisé dans des positions d'implantation des composants, dans lesquelles l'emplacement de la carte (6) à équiper est aligné avec l'outil (9) se trouvant en position d'attente.

4. Appareil pour mettre en place les composants selon la revendication 3, caractérisé par le fait que les positions du support (4) de carte à circuit imprimé pour la mise en place de composants sont déterminées au moyen d'un dispositif d'indexation programmable.

5. Appareil pour mettre en place les composants selon la revendication 3 ou la revendication 4, caractérisé par le fait que le support (4) de carte à circuit imprimé est amené dans les positions de mise en place des composants par un dispositif d'entraînement.

6. Appareil pour mettre en place les composants selon au moins une des revendications précédentes, caractérisé par le fait que l'outil (9) peut être déplacé dans deux directions (X, Y).

7. Appareil pour mettre en place les composants selon au moins une des revendications précédentes, caractérisé par au moins une position de prise en charge, dans laquelle l'outil (9) peut être amené et dans laquelle il peut être déplacé dans la direction Z aux fins de prendre en charge les composants (5) dans le dispositif de stockage (7).

8. Appareil pour mettre en place les composants selon la revendication 7, caractérisé par le fait que l'outil (9) peut être immobilisé dans la position de prise en charge.

9. Appareil pour mettre en place les composants selon la revendication 7 ou la revendication 8, caractérisé par le fait que l'outil (9) est amené dans la position de prise en charge par un moyen d'entraînement.

10. Appareil pour mettre en place les composants selon au moins une des revendications 7 à 9, caractérisé par le fait que l'outil (9) est déplacé de manière automatique dans la direction (Z) dès qu'il atteint la position de prise en charge.

11. Appareil pour mettre en place les composants selon au moins une des revendications précédentes, caractérisé par le fait que le dispositif de stockage (7) peut être amené dans des positions de transfert dans lesquelles les composants (5) à transférer sont alignés avec l'outil (9) en position de prise en charge.

12. Appareil pour mettre en place les composants selon la revendication 11, caractérisé par le fait que le dispositif de stockage (7) peut être immobilisé dans les positions de transfert.

13. Appareil pour mettre en place les composants selon la revendication 11 ou la revendication 12, caractérisé par le fait que les positions de transfert du dispositif de stockage (7) sont déterminées au moyen d'un dispositif d'indexation programmable.

14. Appareil pour mettre en place les composants selon au moins une des revendications 11 à 13, caractérisé par le fait que le dispositif de stockage (7) peut être amené dans les positions de transfert par un moyen d'entraînement.

15. Appareil pour mettre en place les composants selon au moins une des revendications précédentes, caractérisé par le fait que le dispositif de stockage (7) est disposé dans un plan au-dessus du support (4) de carte à circuit imprimé.

16. Appareil pour mettre en place les composants selon la revendication 15, caractérisé par le fait que le dispositif de stockage (7) fait saillie dans la zone de déplacement du support (4) de carte à circuit imprimé.

17. Appareil pour mettre en place les composants selon au moins une des revendications précédentes, caractérisé par le fait qu'il est prévu pour le dispositif de stockage (7) des récipients (30) qui reçoivent chacun un même type de composant (5).

18. Appareil pour mettre en place les composants selon au moins une des revendications précédentes, caractérisé par le fait que le dispositif de stockage (7) comprend une bande transporteuse ou un magasin avec un plateau tournant (66) interchangeable.

19. Appareil pour mettre en place les composants selon au moins une des revendications précédentes, caractérisé par un capot (10) pour le dispositif de stockage (7) et le support (4) de carte à circuit imprimé qui est disposé dans un plan entre l'outil (9) relevé et l'outil abaissé et comporte une ouverture d'accès (35, 36) respectivement pour le passage de l'outil (9) et l'accès au dispositif de stockage (7).

20. Appareil pour mettre en place les composants selon la revendication 19, caractérisé par le fait que le capot (10) est amovible.

21. Appareil pour mettre en place les composants selon la revendication 19 ou la revendication 20, caractérisé par le fait que le capot (10) est en plusieurs parties (31, 32, 33) et que les passages (35, 36) ouverts sur le bord sont disposés dans une partie de couverture (33) ou dans plusieurs parties de couverture (32, 33).

22. Appareil pour mettre en place les composants selon la revendication 21, caractérisé par le fait que le capot (10) comprend au moins une partie de couverture (31) fixe et au moins une partie de couverture (32, 33) coulissante.

23. Appareil pour mettre en place les composants selon au moins une des revendications précédentes, caractérisé par un microscope (37) dont le champ couvre la zone de la carte à circuit imprimé (6) à équiper de composants.

24. Appareil pour mettre en place les composants selon au moins une des revendications précédentes, caractérisé par le fait que le dispositif d'immobilisation d'outil (63) comprend une butée (64) fixe sur une partie bâti (3) de l'appareil de mise en place des composants et une contrebutée (65) sur un bras support (8) portant l'outil (9) et pouvant être déplacée sur la partie bâti (3).

25. Appareil pour mettre en place les composants selon au moins une des revendications 1 à 23, caractérisé par le fait que le dispositif d'immobilisation d'outil (38) comprend un doigt (39) qui peut être déplacé suivant un mouvement de va-et-vient sur la partie bâti (3) et un trou (40) dans le bras-support (8) qui reçoit sensiblement sans jeu ledit doigt (39).

26. Appareil pour mettre en place les composants selon la revendication 25, caractérisé par le fait que le trou (40) comprend une partie de trou (50) intérieure qui reçoit sensiblement sans jeu le doigt (39) et une partie de trou (51) extérieure qui se rétrécit en forme de cône en direction de la partie de trou (50) intérieure et dont la section la plus grande forme une zone de captage pour capter le doigt (39) et déplacer le bras support d'outil (8) jusqu'à ce que ledit doigt (39) pénètre dans la partie de trou (50) intérieure.

27. Appareil pour mettre en place les composants selon la revendication 25 ou la revendication 26, caractérisé par le fait que le doigt (39) est monté à l'extrémité libre du bras (48) d'une manivelle (45) entraînée par le moteur électrique (47).

28. Appareil pour mettre en place les composants selon la revendication 27, caractérisé par un circuit de détection (52) pour détecter les positions de point mort du doigt (39) et pour mettre hors circuit le moteur électrique (47) dès que lesdites positions de point mort sont atteintes.

29. Appareil pour mettre en place les composants selon au moins une des revendications 1 à 23, caractérisé par le fait que le dispositif d'immobilisation d'outil (59) comprend un électro-aimant (60) qui est fixé sur la partie bâti (3) et deux pièces polaires (62) opposées qui sont fixées sur le bras support d'outil (8), un entrefer étant prévu entre les pôles (61) de l'électro-aimant (60) et les pièces polaires opposées (62), lequel entrefer définit avec la puissance de l'électro-aimant (60) une zone de captage pour les pièces polaires opposées (62).

30. Appareil pour mettre en place les composants selon au moins une des revendications 26 à 29, caractérisé par un deuxième circuit de détection (55) qui comporte un capteur (56) fixé sur la partie bâti (3) et un déclencheur de signal (58) fixé sur le bras support d'outil (8) et qui est destiné à déclencher le moteur électrique (47) aux fins d'abaisser le doigt (39) ou à déclencher l'électro-aimant (60) lorsque le capteur (56) arrive dans la zone du déclencheur de signal (58), la zone de déclenchement de signal (5 8) ayant sensiblement la même étendue que la zone de captage de la partie de trou (51) extérieure ou de l'électro-aimant (60).

31. Appareil pour mettre en place les composants selon au moins une des revendications 27 à 30, caractérisé par un troisième circuit de détection pour détecter le déplacement vers le haut de l'outil qui se trouve dans la position d'attente et/ou dans la position de transfert et pour déclencher le moteur électrique (47) aux fins de soulever le doigt (39) et/ou de mettre en service le moyen d'entraînement du dispositif de stockage (7) lorsqu'un déplacement vers le haut est détecté.
